# EUROPEAN PATENT APPLICATION

(11) **EP 1 892 759 A2**
(43) Date of publication of application: **27.02.2008**
(21) Application number: 07109719.0
(22) Date of filing: 06.06.2007
(51) Int. Cl.: H01L 21/8238

(54) **Method for Fabricating dual-metal gate CMOS transistors**

(30) Priority: 22.08.2006 JP 2006225358
(71) Applicant: MATSUSHITA ELECTRIC INDUSTRIAL CO., LTD, Kadoma-shi, Osaka 571-8501 (JP); IMEC vzw, Interuniversitair Microelectronica Centrum vzw, 3001 Leuven (BE)
(72) Inventor: Yamamoto, Kazuhiko, Matsushita Electric Industrial Co., Ltd., Osaka-shi Osaka 540-6319 (JP)
(74) Representative: Grünecker, Kinkeldey, Stockmair & Schwanhäusser Anwaltssozietät

(57) **Abstract**

A method for fabricating a semiconductor device includes the steps of: a) forming an insulating film on a semiconductor substrate; b) forming a first conductive film of a material which does not contain nitrogen on the insulating film; and c) forming a second conductive film of a material containing nitrogen on the first conductive film. The method further includes the step of d) patterning the first conductive film and the second conductive film to form a gate electrode and patterning the insulating film to form a gate insulating film.

## Description

### CROSS-REFERENCE TO RELATED APPLICATION

The disclosure of Japanese Patent Application No. 2006-225358 filed on August 22, 2006 including specification, drawings and claims are incorporated herein by reference in its entirety.

### BACKGROUND OF THE INVENTION

### -Field of the Invention-

The present invention relates to a method for fabricating a semiconductor device, and more particularly relates to a method for fabricating a MOS semiconductor device including a metal gate electrode.

### -Description of the Prior Art-

With recent progress in techniques for increasing the degree of integration and speed of semiconductor devices, the size of MOS field-effect transistors (MOSFETs) has been reduced more and more. For example, in order to reduce the size of MOSFETs, the thickness of conventionally used gate insulating films of silicon oxide (SiO₂), silicon oxynitride (SiON) or the like is reduced. However, as the thickness of gate insulating films is reduced, increase in gate leakage current due to a tunnel current becomes notable or like problem arises. Therefore, to further reduce the thickness of gate insulating films, measures for eliminating such problems have to taken. For example, reduction in capacity resulting from electrode depletion has to be prevented by using, instead of polysilicon gate electrodes, metal electrodes and the like.

As a material for gate insulating films, replacing SiO₂ or SiON with a high-k dielectric material made of metal oxide such as hafnium oxide (HfO₂), zirconium oxide (ZrO₂) and the like has been examined. With use of metal oxide for gate insulating films, it is expected to achieve a silicon oxide film of which a physical thickness is thick and an equivalent silicon oxide film thickness is thin. That is, the effect of reducing leakage current is expected.

However, if a metal oxide film is used as a gate insulating film, due to reaction at an upper interface of the gate insulating film, i.e., an interface between the gate insulating film and a polysilicon gate electrode, an absolute value of a threshold voltage in operating a transistor is increased.

The reason why the reaction occurs is not clearly understood but it is suspected that a substrate processing at a high temperature of about 1000 °C causes reaction between a material of a gate electrode and a material of a gate insulating film.

With a material of a gate electrode and a material of a gate insulating film being reacted with each other, a phenomenon called "Fermi level pinning" in which an effective work function of a gate electrode material is varied occurs. For example, it has been reported that when polysilicon is used as a gate electrode material, a value of an effective work function of polysilicon is fixed at a point slightly closer to a midgap (an intermediate value of bandgap energy) of n⁺ polysilicon than a midgap of silicon without depending on a type of a dopant to be introduced to polysilicon (see "Fermi level pinning at the polySi/metal oxide interface", Proceedings of the 2003 Symposium on VLSI Technology, 2003, pp. 9-10). Because of this phenomenon, particularly, an absolute value of a threshold voltage of a p-type MOSFET becomes considerably large.

Accordingly, when a high-k dielectric gate insulating film is used, not only electrode depletion in a SiO₂ gate insulating film has to be suppressed but also a threshold voltage has to be controlled by using a metal electrode to select an optimal work function.

A tantalum metal material and a tantalum nitride material are known as major electrode materials having a small work function (about 4.2 eV) suitable for an n-MOSFET. Also, a precious metal material, a titanium metal material, a tungsten metal material and nitride of any one of these materials are known as materials having a larger work function (about 5.0 eV) suitable for a p-MOSFET. However, except for precious metal, in terms of properties, a metal simple substance itself which does not form a compound is unstable. Therefore, metal nitride is used as a metal electrode in many cases.

If a metal nitride film is used as a gate electrode, a work function of the metal nitride film is varied depending on a nitrogen composition. For example, a tantalum nitride having a low nitrogen composition is more suitable for an n-MOSFET. This is because with such a tantalum nitride material, the work function is small and a threshold voltage can be reduced. In actual process steps for fabricating a semiconductor device, tantalum nitride having a low nitride composition is easily oxidized and unstable electrically and in terms of properties. Furthermore, when tantalum nitride is used as a gate electrode, excessively contained nitrogen in the gate electrode is diffused in a gate insulating film which is in contact with the gate electrode to deteriorate electrical reliability of a device.

In fabrication of a semiconductor device, it is very important to control nitride concentration and nitride profile but it is not sufficiently done. For example, in physical deposition, sputtering is performed with a target of metal tantalum in mixed plasma atmosphere of argon and nitrogen, thereby depositing tantalum nitride. In this method, part of nitrogen atoms excited during deposition is unintentionally introduced to a gate electrode. Therefore, it is difficult to precisely control a nitrogen composition in an electrode. Moreover, in CVD (chemical vapor deposition) using an organic tantalum material and nitride gas such as ammonia, carbon as an impurity tends to be mixed into an electrode. Therefore, to reduce an amount of carbon impurity in an electrode, an amount of supply of nitride gas has to be increased and a nitrogen composition of a gate electrode can not be reduced.

When a plurality of MOSFETs having different threshold voltages have to be formed on a single wafer, a plurality of metal nitride films having different work functions, i.e., different nitride compositions have to be formed as gate electrodes. In this case, deposition of an electrode film and selective removal have to be repeatedly performed and process steps become complicated.

Furthermore, when a high-k dielectric material is used as a gate insulating film, a trap generated by accumulation of nitrogen in a gate electrode and at an interface between the gate electrode and the gate insulating film causes reduction in electron mobility of a transistor.

### SUMMARY OF THE INVENTION

It is therefore an object of the present invention to solve the above-described problems in known techniques and realize a method for fabricating a semiconductor device which allows, in a MOSFET including a gate electrode of a metal nitride film, control over nitrogen composition in the gate electrode in a simple manner.

To achieve the above-described object, the present invention provides a method for fabricating a semiconductor device in which when a gate electrode is formed, a conductive film which does not contain nitrogen is formed and then a conductive film containing nitrogen is formed.

Specifically, a method for fabricating a semiconductor device according to the present invention includes: a) forming an insulating film on a semiconductor substrate; b) forming a first conductive film of a material which does not contain nitrogen on the insulating film; c) forming a second conductive film of a material containing nitrogen on the first conductive film; and d) patterning the first conductive film and the second conductive film to form a gate electrode and patterning the insulating film to form a gate insulating film.

According to the semiconductor device fabrication method of the present invention, nitrogen secondarily generated when a second conductive film which is a metal nitride film is deposited is captured by a first conductive film. Accordingly, a nitrogen composition in part of a gate electrode located directly on a gate insulating film can be controlled by a thickness of the first conductive film and thus a work function of the gate electrode can be set to be an optimal value. Accordingly, a MOSFET of which a threshold voltage is small can be formed. Assume that part of the gate electrode located directly on the gate insulating film is formed of a metal substance which does not form a compound. Even in such a case, because exposed surface side part of the gate electrode is conductive nitride, properties of the gate electrode are not varied even when the gate electrode is exposed to an oxidizing atmosphere in the subsequent step. Furthermore, nitrogen can be prevented from reaching the gate insulating film and the generation of a carrier trap in the gate insulating film can be suppressed.

It is preferable that the semiconductor device fabrication method of the present invention further includes, between the step b) and the step c), the step e) of selectively etching the first conductive film to provide a region in the first conductive film on the semiconductor substrate which has a different thickness from a thickness of other regions of the first conductive film. In the semiconductor device fabrication method of the present invention, it is preferable that the semiconductor substrate includes a region in which an n-type transistor is to be formed and a region in which a p-type transistor is to be formed, and in the step e), the first conductive film is processed to have a smaller thickness in the region in which a p-type transistor is to be formed than a thickness in the region in which an n-type transistor is to be formed. In this case, in the step of e), part of the first conductive film located in the region in which a p-type transistor is to be formed may be removed. By forming a semiconductor device having the above-descried structure, a gate electrode of which a nitrogen composition is low and a work function is small can be formed in an n-type transistor formation region and a gate electrode of which a nitride composition is high and a work function is large can be formed in a p-type MOS transistor formation region.

In the semiconductor device fabrication method of the present invention, it is preferable that the first conductive film is formed of any one of tantalum, titanium, tungsten, a rare-earth element and silicide or carbide of tantalum, titanium, tungsten or the rare-earth element, or an alloy containing two or more of tantalum, titanium, tungsten, a rare-earth element and silicide or carbide of tantalum, titanium, tungsten or the rare-earth element.

In the semiconductor device fabrication method of the present invention, it is preferable that the second conductive film is formed of any one of tantalum nitride, titanium nitride, tungsten nitride and nitride of a rare-earth element, or an alloy containing two or more of tantalum nitride, titanium nitride, tungsten nitride and nitride of a rare-earth element.

In the semiconductor device fabrication method of the present invention, it is preferable that in the step of b), the first conductive film is formed by physical vapor deposition.

In the semiconductor device fabrication method of the present invention, it is preferable that in the step of c), the second conductive film is formed by physical vapor deposition, chemical vapor deposition or atomic layer deposition.

It is preferable that the semiconductor device fabrication method of the present invention further includes, between the step c) and the step d), the step f) of forming a third conductive film on the second conductive film.

It is preferable that the semiconductor device fabrication method of the present invention further includes, after the step e), the step g) of forming sidewalls on side surfaces of the gate electrode, respectively.

It is preferable that the semiconductor device fabrication method of the present invention further includes, after the step g), the steps of: h) forming source/drain regions on both sides of the gate electrode in the semiconductor substrate, respectively, and i) performing silicidation to the source/drain regions.

### BRIEF DESCRIPTION OF THE DRAWINGS

FIGS. **1A** through 1**D** are cross-sectional views illustrating respective steps for fabricating a semiconductor device according to an embodiment of the present invention in order of fabrication steps.
FIGS. **2A** through **2C** are cross-sectional views illustrating respective steps for fabricating the semiconductor device according to the embodiment of the present invention in order of fabrication steps.
FIG. **3** is a graph showing threshold voltage for MOSFETs formed according to a semiconductor device fabrication method in accordance with an embodiment of the present invention.
FIG. **4** is a graph showing interface state density for MOSFETs formed according to a semiconductor device fabrication method in accordance with an embodiment of the present invention.
FIG. **5** is a graph showing life time for MOSFETs formed according to a semiconductor device fabrication method in accordance with an embodiment of the present invention under a condition where voltage application stress is applied.

### DESCRIPTION OF THE PREFERRED EMBODIMENTS

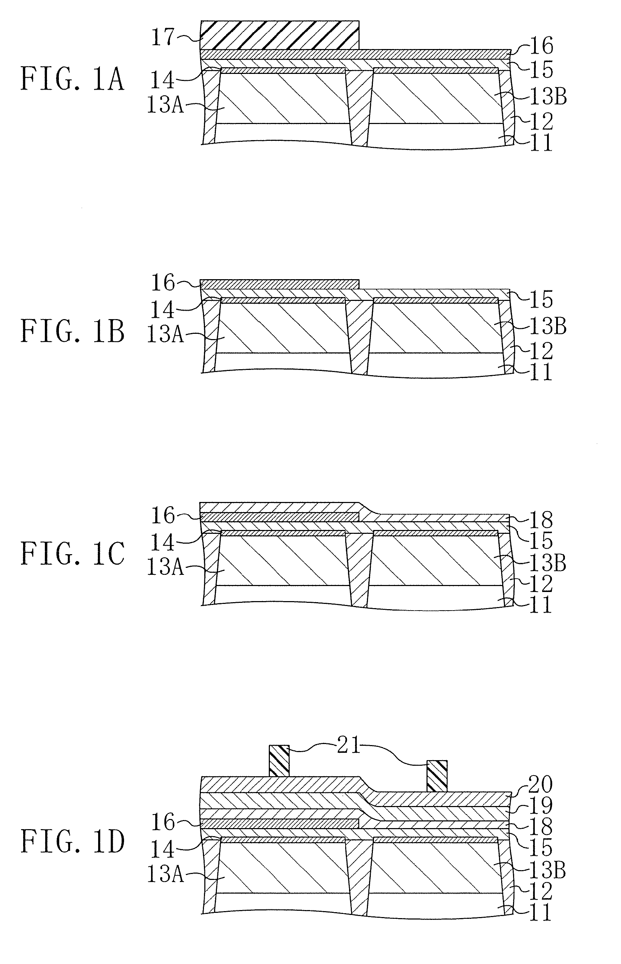

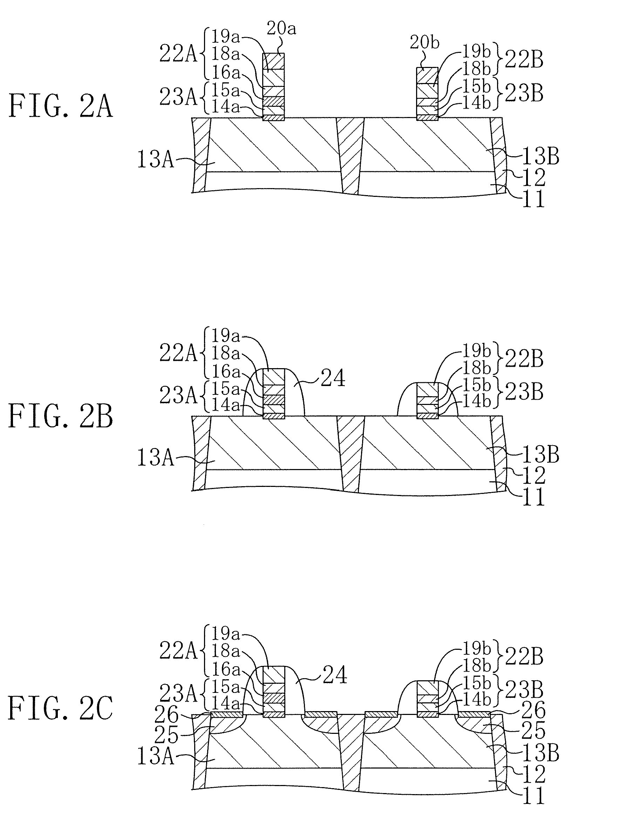

An embodiment of the present invention will be described with reference to the accompanying drawings. FIGS. **1A** through **1D** and FIGS. **2A** through **2C** are cross-sectional views illustrating respective steps for fabricating a semiconductor device according to an embodiment of the present invention in order.

First, as shown in FIG. **1A,** for example, an isolation film of shallow trench isolation (STI) is selectively formed in upper part of a substrate **11** made of silicon of which a principal surface has a plane orientation of (100).

Subsequently, ion implantation is performed to the substrate **11**, thereby forming a plurality of n-type transistor formation regions **13A** and a plurality of p-type transistor formation regions **13B** are formed in the substrate **11**. Each of the n-type transistor formation regions **13A** has a p-type well and each of the p-type transistor formation regions **13B** has an n-type well.

Thereafter, known standard RCA cleaning (i.e., wet cleaning based on ammonia hydrogen peroxide solution cleaning and hydrochloric acid hydrogen peroxide solution cleaning) and diluted hydrofluoric acid cleaning are performed in this order to a surface of the substrate **11** and then heat treatment is performed to the cleaned substrate 11, for example, in an oxidizing atmosphere at a temperature of about 600 °C to 1000 °C. Thus, an underlying film **14** is formed of silicon oxide so as to be located over the n-type transistor formation regions **13A** and the p-type transistor formation regions 13B in the substrate **11.** The underlying film **14** may be formed of, instead of SiO₂, silicon nitride, silicon oxynitride or the like.

Next, an insulating film **15** is formed of a metal oxide film of a high-k dielectric material over the underlying film **14**, for example, using MOCVD, so as to have a thickness of 3 nm. The underlying film **14** and the insulating film **15** serve as a gate insulating film of a MOSFET to be formed in each device formation region.

The insulating film **15** is formed in the following manner. For example, a carrier gas of nitrogen or the like is blown into Hf(O-t-C₃H₇)₄ which is a liquid hafnium source (Hf source) and Si(O-t-C₃H₇)₄ which is a liquid silicon source (Si source) and bubbling is performed. By this bubbling, a source gas in a form of gas of the Hf source and the Si source is generated and the generated source gas is introduced into a reaction furnace with the carrier gas. Thus, the insulating film **15** of hafnium silicate which is a metal oxide film containing silicon is deposited. A temperature in the reaction furnace may be set at about 500 °C. A concentration of Hf with respect to Si of deposited hafnium silicate can be adjusted according to a supply amount of each of the Hf source and the Si source. The insulating film **15** may be deposited by, instead of MOCVD, physical deposition (sputtering), atomic layer deposition, laser ablation or molecular beam epitaxy. Instead of hafnium oxide, zirconium oxide, titanium oxide, tantalum oxide, aluminum oxide, lanthanum oxide, or oxide of at least one of hafnium, zirconium, titanium, tantalum, aluminum, silicon, lanthanum and a rare earth element may be used.

Next, using sputtering, metal tantalum is deposited over the insulating film **15**, thereby forming a first conductive film **16**. The first conductive film **16** may be formed, for example, by performing sputtering using a metal tantalum target in an argon gas atmosphere at a pressure of about 0.4 kPa. The first conductive film **16** may be formed of, instead of tantalum, titanium, tungsten, a rare earth element or silicide or carbide of tantalum, titanium, tungsten or a rare earth element. The first conductive film **16** may also be formed of an alloy containing any two of tantalum, titanium, tungsten, a rare earth element and silicide and carbide of tantalum, titanium, tungsten, a rare earth element.

Next, a resist is applied to an entire surface of a wafer and then a resist film **17** is selectively formed by photolithography so as to over the n-type transistor formation regions.

Next, as shown in FIG. **1B,** dry etching is performed using a mixed gas of chlorine and hydrogen bromide, thereby removing part of the first conductive film **16** located over the p-type transistor formation regions. In FIG. **1B**, the example where the part of the first conductive film **16** located over the p-type transistor formation regions is completely removed, but etching may be stopped halfway so that the first conductive film **16** having a small thickness is left over the p-type transistor formation regions **13B**. Subsequently, the resist film **17** is removed using an SPM solution (i.e., a mixed liquid solution of sulfuric acid, hydrogen peroxide solution and water).

Next, as shown in FIG. **1C,** using sputtering, tantalum nitride is deposited over the wafer to a thickness of 10 nm, thereby forming a second conductive film **18**. The second conductive film **18** may be formed, for example, by performing sputtering using a metal tantalum target in a mixed gas atmosphere of argon and nitrogen at a pressure of about 0.4 kPa. Sputtered tantalum atoms from the metal tantalum target are deposited over the wafer and, at the same time, reacts with plasmatized nitrogen, so that tantalum nitride is formed. The second conductive film **18** may be formed of, instead of tantalum nitride, titanium nitride, tungsten nitride or the like. A metal nitride film containing a rare earth element, silicon or carbon may be used. Also, an alloy of such metal nitride may be used.

Next, as shown in FIG. **1D,** a third conductive film **19** is formed over the second conductive film **18**. As the third conductive film **19**, a metal film of tungsten or the like, a polysilicon film, an amorphous silicon film, a doped polysilicon film, a doped amorphous silicon film or the like may be used. The third conductive film **19** preferably has a thickness of about 100 nm.

Subsequently, a hard mask formation film **20** is formed of silicon oxide, silicon nitride or the like so as to have a thickness of about 100 nm. Thereafter, a resist film **21** is formed on the hard mask formation film **20** so as to cover part of the hard mask formation film **20** which is to be a gate electrode.

Next, as shown in FIG. **2A**, the hard mask formation film **20** is etched using the resist film **21,** thereby forming a hard mask **20a** in each of the n-type transistor formation regions **13A** and a hard mask **20b** in each of the p-type transistor formation regions **13B**. Furthermore, in each of the n-type transistor formation regions **13A**, using the hard mask **20a,** the third conductive film **19,** the second conductive film **18** and the first conductive film **16** are etched, thereby forming a first gate electrode **22A** including a third conductive film **19a,** a second conductive film **18a** and a first conductive film **16a.** The insulating film **15** and the underlying film **14** are etched, thereby forming a first gate oxide film **23A** including an insulating film **15a** and an underlying film **14a.**

In each of the p-type transistor formation regions **13B**, using the hard mask **20b**, the third conductive film **19** and the second conductive film **18** are etched, thereby forming a second gate electrode **22B** including a third conductive film **19b** and a second conductive film **18b**, and the insulating film **15** and the underlying film **14** are etched, thereby forming a second gate oxide film **23B** including an insulating film **15b** and an underlying film **14b**.

Next, using known ion implantation, an n-type impurity is ion implanted into the n-type transistor formation regions **13A** and a p-type impurity is ion implanted into the p-type transistor formation regions **13B**, thereby forming extension regions (not shown). Then, the hard mask **20a** is removed from over the first gate electrode **22A** and the second gate electrode **22B**.

Next, as shown in FIG. **2B**, an insulating film such as a silicon nitride or the like is deposited over the wafer and then the silicon nitride film is etched by anisotropic etching to form a sidewall **24** on each of side surfaces of the first gate electrode **22A** and the second gate electrode **22B**.

Next, as shown in FIG. **2C**, an n-type impurity is ion implanted into the n-type transistor formation regions **13A** and a p-type impurity is ion implanted into the p-type transistor formation regions **13B,** thereby forming source/drain regions **25.** Then, heat treatment is performed at a temperature of 1000 °C or more to activate the ion implanted impurities.

Subsequently, nickel is deposited over the wafer and then heat treatment is performed at a temperature of 300 °C to silicidize surfaces of the source/drain regions **25**. Next, using an SPM solution, unreacted nickel is removed and then heat treatment for stabilizing a crystalline phase is performed, thereby forming a nickel silicide **26**. Furthermore, although not shown in the drawings, an interconnect and the like are formed, so that a semiconductor device including a MOS transistor is obtained.

According to a method for fabricating a semiconductor device of this embodiment, in the n-type transistor formation regions **13A**, a first conductive film **16** which does not contain nitrogen is deposited and then a second conductive film **18** which is a metal nitride film is deposited. Thus, in each n-type MOSFET, part of the first conductive film **16** located directly on a gate oxide film can be formed of a metal film which does not contain nitrogen or a metal film of which a nitrogen composition is very low. A threshold of a transistor is determined according to properties of a conductive film directly on a gate insulating film and, therefore, even when the second conductive film **18** as an upper layer is formed of a metal nitride film of which a work function is large, a threshold voltage of an n-type MOSFET can be suppressed to be a low level.

According to the semiconductor device fabrication method of this embodiment, upper part of a gate electrode is formed of a metal nitride film. Thus, compared to the case where only a metal simple substance itself which does not form a compound is used for a gate electrode, properties of a film is easily stabilized and variations and fluctuation in properties can be suppressed.

When the second conductive film **18** is deposited over the first conductive film **16**, plasmatized nitrogen is used for the purpose of forming the second conductive film into a metal nitride film. Plasmatized nitrogen is active and reacts also with metal on a surface of the first conductive film **16**. However, by forming the first conductive film **16** so as to have a larger thickness than a diffusion distance that diffusion of plasmatized nitrogen reaches, nitrogen can be prevented from reaching the insulating film **15** which is a gate insulating film. Accordingly, part of the first conductive film located directly on the gate insulating film can be formed of a metal film which does not contain nitrogen. Introduction of nitrogen to the gate insulating film can be also prevented, so that the generation of a carrier trap can be prevented. Introduction of nitrogen can be controlled by changing the thickness of the first conductive film **16** so that nitrogen is introduced into part of the first conductive film **16** located directly on the gate insulating film. Thus, a threshold voltage can be controlled to be a desired value.

In the p-type transistor formation regions 13B, the second conductive film **18** of a metal nitride film is formed directly on the gate insulating film. Thus, a work function of the gate electrode can be increased and a threshold of a p-type MOSFET can be reduced.

In a p-type MOSFET, a metal nitride film of tantalum nitride or the like is formed directly on the gate insulating film and thus there might be cases where nitrogen is introduced into the gate insulating film and a carrier trap is generated. However, carriers in a p-type MOSFET are holes and influences of a defect density on the mobility of holes, i.e., current driving power are small. Therefore, compared to an n-type MOSFET, influences of a carrier trap are limited and transistor properties are not largely deteriorated.

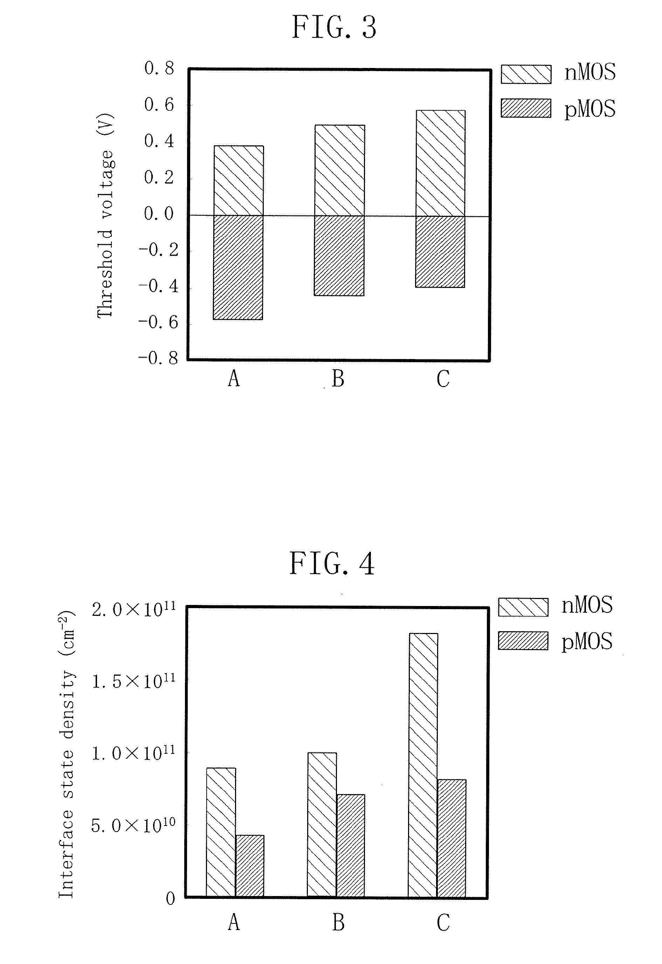

Hereafter, results of measurements for properties of semiconductor devices formed according to the semiconductor device fabrication method of this embodiment will be described. FIG. 3 shows threshold voltage for semiconductor devices **A**, **B** and **C** formed according to this embodiment. Each of n-type MOSFETs and p-type MOSFETs of FIG. **3** has a gate electrode having the same structure in which a first conductive film **16** and a second conductive film **18** are stacked. A nitrogen composition in a region of a gate electrode located around an interface with a gate insulating film differs between the semiconductor devices **A**, **B** and **C**. Specifically, the nitrogen composition is increased in the order of **A**, **B** and **C**. In the semiconductor device **A**, a nitrogen composition indicates that the region is almost completely metal tantalum. A nitrogen composition in a region of a gate electrode located around an interface with a gate insulating film is controlled by changing a thickness of the first conductive film **16**. More specifically, in the semiconductor **A**, metal tantalum is formed directly on a gate insulating film so as to have a thickness of about 2 nm and a tantalum nitride film is stacked on the metal tantalum. In each of the semiconductor devices **B** and **C**, a tantalum nitride film is formed on a gate insulating film. Specifically, in the semiconductor device **C**, nitrogen is more excessively introduced by increasing a nitrogen partial pressure of a mixed gas of argon and nitrogen in forming a tantalum nitride film.

As shown in FIG. **3**, a threshold voltage of an n-type MOSFET in the semiconductor device **A** in which almost no nitrogen is contained in a region of a gate electrode located around an interface with a gate insulating film is about 0.4 V. However, a composition of nitrogen contained in a gate insulating film is increased in the semiconductor devices **B** and **C** in this order, and threshold voltage for the n-type MOSFETs is increased as a work function is increased.

For the p-type MOSFETs in the semiconductor devices of **A, B** and **C,** in contrast to the n-type MOSFETs in the semiconductor devices of **A, B** and **C,** a nitrogen composition in a region of a gate electrode located around an interface with a gate insulating film is increased in the order of the semiconductor device **A**, **B** and **C**, and thus a work function also is increased in the same manner. As the work function is increase, a threshold voltage is reduced.

A first conductive film of a metal film which does not contain nitrogen is formed in n-type transistor formation regions and p-type transistor formation regions and then part of the first conductive film located in each of the p-type transistor formation regions is removed or a thickness of the part is reduced so as to be smaller than a thickness of part of the first conductive film located in each of the n-type transistor formation regions. Thus, a threshold voltage of each of n-type MOSFETs and p-type MOSFETs in a semiconductor device can be suppressed to a low level. Moreover, if an n-type MOSFET having a high threshold voltage is needed, the first conductive film may be removed or the thickness of the first conductive film may be reduced in a MOSFET formation region in which an n-type MOSFET having a high threshold voltage is to be formed. If a p-type MOSFET having a high threshold voltage is needed, the first conductive film may be left with a large thickness in a MOSFET formation region in which a p-type MOSFET having a high threshold voltage is to be formed. Thus, ion implantation performed to a silicon substrate for the purpose of control of a threshold voltage does not have to be used. Therefore, a MOSFET having high current driving power can be achieved without reducing mobility of carries.

FIG. **4** shows interface state density for MOSFETs in the semiconductor devices **A, B** and **C** formed according to a semiconductor device fabrication method of this embodiment. In an n-type MOSFET, the number of traps at an interface between a gate insulating film and a silicon substrate is increased as a nitrogen concentration is increased. However, in an n-type MOSFET, a region having a low nitrogen composition is formed in order to suppress a threshold voltage to a low level and thus no problem is caused. Also, in a p-MOSFET, the number of traps is increased as a nitrogen concentration is increased. However, in a p-type MOSFET, carriers in a transistor operation are holes and thus influences of the generation of traps due to introduction of nitrogen are small, compared to an n-type MOSFET. Thus, in a p-type MOSFET, even if a nitrogen composition may be increased to suppress a threshold voltage to a low level, no problem is caused.

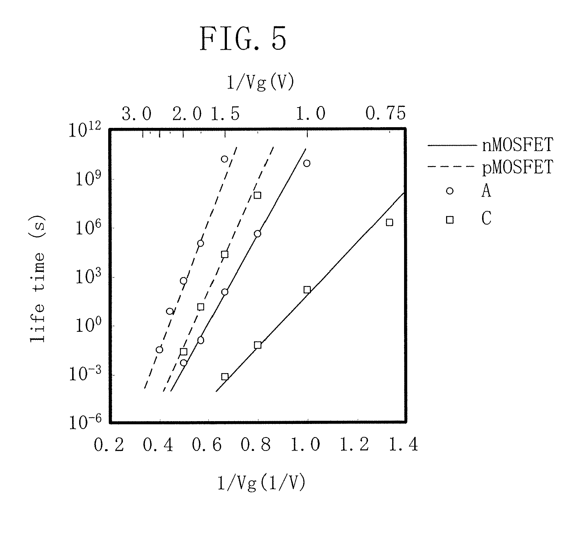

FIG. 5 is a graph showing life time for MOSFETs in the semiconductor devices A and C formed according to a semiconductor device fabrication method of this embodiment under a condition where voltage application stress is applied.

As shown in FIG. 5, in n-type MOSFETs, a fluctuation of threshold voltage is smaller and a MOSFET is less likely to be deteriorated in the semiconductor device A in which a nitride composition of a gate electrode is low. This is because in an n-type MOSFET, as described above, when a nitrogen composition of a gate electrode is increased, an interface state density is increased and electrons captured by a trap are increased by electric field stress at a high temperature.

Also, in p-type MOSFETs, when a nitride composition of a gate electrode is low, fluctuation of a threshold voltage is smaller and a MOSFET is less likely to be deteriorated. However in a p-type MOSFET, because the degree of deterioration is small, compared to an n-type MOSFET, even if a nitrogen composition of a gate electrode is increased for the purpose of reducing a threshold voltage, there is no problem from practical stand point.

In this embodiment, the example where an n-type MOSFET and a p-type MOSFET are formed in a single substrate has been described. However, the present invention is applicable to the case where only one of an n-type MOSFET and a p-type MOSFET is formed.

As has been described, according to the present invention, a semiconductor device fabrication method which allows, in a MOSFET including a gate electrode of a metal nitride film, control over nitrogen composition of the gate electrode in a simple manner and thus is useful as a method for fabricating a semiconductor device including a metal nitride film in a gate electrode.

## Claims

1. A method for fabricating a semiconductor device, comprising the steps of:
a) forming an insulating film on a semiconductor substrate;
b) forming a first conductive film of a material which does not contain nitrogen on the insulating film;
c) forming a second conductive film of a material containing nitrogen on the first conductive film; and
d) patterning the first conductive film and the second conductive film to form a gate electrode and patterning the insulating film to form a gate insulating film.

2. The method of claim 1, further comprising, between the step b) and the step c), the step e) of selectively etching the first conductive film to provide a region in the first conductive film on the semiconductor substrate which has a different thickness from a thickness of other regions of the first conductive film.

3. The method of claim 2, wherein the semiconductor substrate includes a region in which an n-type transistor is to be formed and a region in which a p-type transistor is to be formed, and
wherein, in the step e), the first conductive film is processed to have a smaller thickness in the region in which a p-type transistor is to be formed than a thickness in the region in which an n-type transistor is to be formed.

4. The method of claim 3, wherein, in the step of e), part of the first conductive film located in the region in which a p-type transistor is to be formed is removed.

5. The method of claim 1, wherein the first conductive film is formed of any one of tantalum, titanium, tungsten, a rare-earth element and silicide or carbide of tantalum, titanium, tungsten or the rare-earth element, or an alloy containing two or more of tantalum, titanium, tungsten, a rare-earth element and silicide or carbide of tantalum, titanium, tungsten or the rare-earth element.

6. The method of claim 1, wherein the second conductive film is formed of any one of tantalum nitride, titanium nitride, tungsten nitride and nitride of a rare-earth element, or an alloy containing two or more of tantalum nitride, titanium nitride, tungsten nitride and nitride of a rare-earth element.

7. The method of claim 6, wherein the second conductive film contains at least one of silicon or carbon.

8. The method of claim 1, wherein, in the step of b), the first conductive film is formed by physical vapor deposition.

9. The method of claim 1, wherein, in the step of c), the second conductive film is formed by physical vapor deposition, chemical vapor deposition or atomic layer deposition.

10. The method of claim 1, further comprising, between the step c) and the step d), the step f) of forming a third conductive film on the second conductive film.

11. The method of claim 1, further comprising, after the step e), the step g) of forming sidewalls on side surfaces of the gate electrode, respectively.

12. The method of claim 11, further comprising, after the step g), the steps of:
h) forming source/drain regions on both sides of the gate electrode in the semiconductor substrate, respectively, and
i) performing silicidation to the source/drain regions.
